(19) **Europäisches Patentamt / European Patent Office / Office européen des brevets**

(11) **EP 4 745 091 A1**

(12) # EUROPEAN PATENT APPLICATION

(43) Date of publication:
20.05.2026 Bulletin 2026/21

(21) Application number: 25211640.5

(22) Date of filing: 28.10.2025

(51) International Patent Classification (IPC):
$C01G\ 53/504^{(2025.01)}$ $H01M\ 4/505^{(2010.01)}$
$H01M\ 4/525^{(2010.01)}$ $H01M\ 10/0525^{(2010.01)}$

(52) Cooperative Patent Classification (CPC):
**C01G 53/504; H01M 4/505; H01M 4/525;
H01M 10/0525;** C01P 2002/76; C01P 2004/03;
C01P 2004/84; C01P 2006/40; C01P 2006/80

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 30.10.2024 KR 20240150926

(71) Applicant: **ECOPRO BM CO., LTD.**
**Cheongju-si, Chungcheongbuk-do 28116 (KR)**

(72) Inventors:
• **SON, Yu Jin**
**Cheongju-si, Chungcheongbuk-do 28116 (KR)**
• **HEO, Jun Hee**
**Cheongju-si, Chungcheongbuk-do 28116 (KR)**

• **LEE, Sang Don**
**Cheongju-si, Chungcheongbuk-do 28116 (KR)**
• **PARK, Jung Bae**
**Cheongju-si, Chungcheongbuk-do 28116 (KR)**
• **SHIN, Yo Seop**
**Cheongju-si, Chungcheongbuk-do 28116 (KR)**
• **HWANG, Do Young**
**Cheongju-si, Chungcheongbuk-do 28116 (KR)**
• **KIM, Seok Jo**
**Cheongju-si, Chungcheongbuk-do 28116 (KR)**
• **CHOI, Woo Seok**
**Cheongju-si, Chungcheongbuk-do 28116 (KR)**
• **PARK, Jung Gyu**
**Cheongju-si, Chungcheongbuk-do 28116 (KR)**

(74) Representative: **Vossius & Partner**
**Patentanwälte Rechtsanwälte mbB**
**Siebertstraße 3**
**81675 München (DE)**

(54) **POSITIVE ELECTRODE ACTIVE MATERIAL AND LITHIUM SECONDARY BATTERY INCLUDING THE SAME**

(57) The present invention relates to a positive electrode active material and a lithium secondary battery comprising the same, and more particularly, to a positive electrode active material which exhibit improved driving characteristics under high-voltage operating conditions through surface modification of a lithium transition metal oxide of a Mid-Ni type having a relatively low nickel content, and to a lithium secondary battery comprising the same.

FIG. 1

EP 4 745 091 A1

**Description**

BACKGROUND

**1. Field of the Invention**

The present invention relates to a positive electrode active material and a lithium secondary battery comprising the same, and more particularly, to a positive electrode active material which exhibit improved driving characteristics under high-voltage operating conditions through surface modification of a lithium transition metal oxide of a Mid-Ni type having a relatively low nickel content, and to a lithium secondary battery comprising the same.

**2. Discussion of Related Art**

Batteries store power by using materials capable of undergoing electrochemical reactions at a positive electrode and a negative electrode. A representative example of batteries is a lithium secondary battery that stores electrical energy by the difference in chemical potential when lithium ions are intercalated/deintercalated into/from the positive electrode and the negative electrode.

The lithium secondary battery is manufactured by using materials capable of reversible intercalation/deintercalation of lithium ions as positive and negative electrode active materials and filling an organic electrolyte or a polymer electrolyte between the positive and negative electrodes.

A lithium transition metal oxide is used as a positive electrode active material for a lithium secondary battery, and as an example, composite oxides such as $LiCoO_2$, $LiMn_2O_4$, $LiNiO_2$, $LiMnO_2$, and the like are being studied.

Among the positive electrode active materials, $LiCoO_2$ is the most widely used due to its excellent lifetime characteristics and charge/discharge efficiency, but it has limitations in price competitiveness because cobalt, which is used as a raw material, is expensive due to resource constraints.

Lithium manganese oxides such as $LiMnO_2$ and $LiMn_2O_4$ have advantages of excellent thermal safety and low price, but also have problems of low capacity and poor high-temperature characteristics. In addition, a $LiNiO_2$-based positive electrode active material exhibits battery characteristics such as high discharge capacity, but it is difficult to synthesize the $LiNiO_2$-based positive electrode active material due to cation mixing between Li and transition metals, thereby causing significant problems in rate characteristics.

Therefore, in order to improve the low rate and cycle characteristics of $LiNiO_2$ while maintaining its high reversible capacity, ternary lithium transition metal oxides such as the so-called NCM (Ni-Co-Mn) and NCA (Ni-Co-Al), in which part of the nickel is substituted with cobalt, manganese, and/or aluminum, or quaternary lithium transition metal oxides such as NCMA (Ni-Co-Mn-Al) have been developed. Since the reversible capacity is reduced as the nickel content in the ternary or quaternary lithium transition metal oxide decreases, research has been widely conducted to increase the nickel content in the lithium transition metal oxide.

However, as the content of nickel in the lithium transition metal oxide increases, cation mixing increases in the crystal structure, thereby reducing stability or increasing the content of unreacted lithium impurities such as LiOH and $Li_2CO_3$ on the surface.

As the content of lithium impurities remaining on the surface of the lithium transition metal oxide increases, gas generation and swelling may be promoted in a lithium secondary battery using the lithium transition metal oxide as a positive electrode active material. As the content of lithium impurities remaining on the surface of the lithium transition metal oxide increases, a paste composition becomes gel-like due to lithium impurities when a paste for forming a positive electrode active material layer is prepared using the lithium transition metal oxide.

Accordingly, a washing process needs to be performed in the manufacturing process of the positive electrode active material to remove lithium impurities remaining on the surface of the lithium transition metal oxide. However, as the surface of the lithium transition metal oxide is damaged through this washing process, the electrochemical properties and stability of the lithium secondary battery using the lithium transition metal oxide as a positive electrode active material are degraded, and in particular, the problem of premature degradation of lifetime may occur.

In addition, as the demand for lithium secondary batteries has recently grown rapidly and the cost of raw materials has also increased, the lithium secondary battery market has faced a strong demand for cost reduction. In particular, the positive electrode active material accounts for the largest proportion of the material cost in lithium secondary batteries, and the cost of the positive electrode active material inevitably increases as the nickel content, which is an essential element of ternary or quaternary lithium transition metal oxides, increases.

That is, although an increase in the nickel content in the positive electrode active material improves reversible capacity, it also causes problems such as an increase in lithium impurities in the positive electrode active material and a rise in the cost of the positive electrode active material, resulting in a trade-off relationship.

Accordingly, there is a need to develop a mid-Ni type positive electrode active material capable of solving problems such as a decrease in electrochemical characteristics caused by reducing the nickel content in the positive electrode active material, while achieving the goals of improving stability and reducing cost by lowering the nickel content in the positive electrode active material.

## SUMMARY OF THE INVENTION

In the lithium secondary battery market, the growth of lithium secondary batteries for electric vehicles has been playing a leading role, and accordingly, the demand for positive electrode active materials used in lithium secondary batteries has also been continuously increasing.

For example, conventionally, lithium secondary batteries using lithium iron phosphate (LFP) have mainly been used from the perspective of ensuring safety; however, recently, the use of nickel-based lithium transition metal oxides, which have higher energy capacity per weight compared to LFP, has been expanding (although relatively inexpensive LFP is still used to reduce costs in some cases).

In addition, nickel-based lithium transition metal oxides, which are mainly used as positive electrode active materials for high-capacity lithium secondary batteries, typically have a ternary composition such as NCM (Ni-Co-Mn) or NCA (Ni-Co-Al) containing about 70 to 80 mol% or more of nickel, or a quaternary composition such as NCMA (Ni-Co-Mn-Al).

However, as described above, although increasing the nickel content in the lithium transition metal oxide improves reversible capacity, it can also cause problems such as an increase in lithium impurities in the positive electrode active material and deterioration of the stability of the positive electrode active material. Moreover, this inevitably leads to a trade-off problem, such as an increase in the cost of the positive electrode active material.

On the other hand, when a content of nickel in a lithium transition metal oxide is reduced in order to achieve the goal of cost reduction of a positive electrode active material, electrochemical properties such as low-temperature output characteristics may deteriorate. As a result, the material may be unsuitable for exhibiting appropriate driving characteristics under high-voltage operating conditions.

Accordingly, an object of the present invention is to provide a positive electrode active material comprising a lithium transition metal oxide of a Mid-Ni type having a relatively low content of nickel (for example, about 70 mol% or less, or about 65 mol% or less), wherein surface modification of the lithium transition metal oxide enhances electrochemical performance compared to that of a High-Ni-type lithium transition metal oxide having a relatively high content of nickel.

Another object of the present invention is to provide a positive electrode active material in which a tungsten-containing coating layer is formed on the surface of the lithium transition metal oxide, thereby improving discharge capacity and rate characteristics.

A further object of the present invention is to provide a positive electrode active material comprising a lithium transition metal oxide of a Mid-Ni type having a relatively low content of nickel (for example, about 70 mol% or less, or about 65 mol% or less), in which surface modification of the lithium transition metal oxide reduces residual lithium on the surface and suppresses side reactions between the lithium transition metal oxide and the electrolyte during charging and discharging, thereby improving stability.

Still another object of the present invention is to provide a lithium secondary battery using the positive electrode active material defined herein.

The objects of the present invention are not limited to those mentioned above, and other objects and advantages of the present invention that are not described can be understood from the following description and will be more clearly understood by the embodiments of the present invention. It will also be readily apparent that the objects and advantages of the present invention can be realized by means and combinations thereof as defined in the claims.

According to one aspect of the present invention, there is provided a positive electrode active material comprising a lithium transition metal oxide capable of intercalation/deintercalation of lithium, wherein the lithium transition metal oxide has at least one form selected from a form of a single particle consisting of a single unit particle and a form of a quasi-single particle form consisting of 30 or less unit particles aggregated.

According to one aspect of the present invention, there is provided a positive electrode active material comprising: a lithium transition metal oxide having a crystal structure belonging to the R-3m space group and having a content of nickel in the range of 40 mol% to 70 mol% among the transition metals; and a tungsten-containing coating layer located on the surface of the lithium transition metal oxide, whereby residual lithium on the surface is reduced, and surface side reactions between the lithium transition metal oxide and the electrolyte during charge and discharge are suppressed, thereby improving stability.

According to the present invention, there is also provided a positive electrode active material having improved discharge capacity and rate characteristics through surface modification of the lithium transition metal oxide.

The positive electrode active material defined herein may have a lattice strain of 0.00025 or less, calculated through Rietveld Refinement of an X-ray diffraction (XRD) spectrum obtained using Cu-K$\alpha$ radiation, by forming a tungsten-containing coating layer on the surface of the lithium transition metal oxide.

The lithium transition metal oxide includes at least lithium and transition metals, and a content of nickel among the transition metals may be in the range of 40 mol% to 70 mol%, 45 mol% to 70 mol%, 50 mol% to 70 mol%, 55 mol% to 65 mol%, or 60 mol% to 65 mol%.

A content of cobalt among the transition metals may be 10 mol% or less, 2.5 mol% to 10 mol%, or 5 mol% to 10 mol%. A content of manganese among the transition metals may be in the range of 20 mol% to 50 mol%, 20 mol% to 45 mol%, 20 mol% to 40 mol%, 25 mol% to 35 mol%, or 27 mol% to 33 mol%.

The lithium transition metal oxide may further comprise cobalt and manganese as transition metals, and a content of manganese among the transition metals may be greater than a content of cobalt.

The lithium transition metal oxide may have a composition represented by Chemical Formula 1 below:

$$[\text{Chemical Formula 1}] \qquad Li_aNi_{1-(b+c+d)}Co_bMn_cM1_dO_2$$

wherein, in the above Chemical Formula 1,

M1 is at least one selected from Na, K, Mg, Ca, Sr, Ba, Rb, B, Ce, Hf, Ta, Cr, F, Al, V, Ti, Fe, Zr, Zn, Si, Y, Nb, Ga, Sn, Mo, W, P, Ge, Nd, Gd, and Cu; and
$0.95 \leq a \leq 1.15$, $0 \leq b \leq 0.10$, $0.20 \leq c \leq 0.50$, $0 \leq d \leq 0.10$, and $0.4 \leq 1-(b+c+d) \leq 0.7$.

As defined herein, when a content of manganese in the lithium transition metal oxide of a Mid-Ni type having a relatively low content of nickel becomes higher than a content of cobalt, surface kinetic characteristics such as lithium-ion conductivity tend to decrease, thereby deteriorating rate characteristics.

However, herein, by forming a tungsten-containing coating layer on the surface of the lithium transition metal oxide, the efficiency of reversible lithium-ion intercalation and deintercalation through the lithium transition metal oxide can be enhanced, thereby improving electrochemical performance compared to that of a High-Ni-type lithium transition metal oxide having a relatively high content of nickel.

In addition, in order to enhance the efficiency of reversible lithium-ion intercalation and deintercalation through the lithium transition metal oxide and thereby improve electrochemical performance compared to a High-Ni-type lithium transition metal oxide having a relatively high content of nickel, the lithium transition metal oxide may have at least one form selected from a single particle form composed of one unit particle and a quasi-single particle form in which 30 or fewer unit particles are aggregated.

An average particle diameter ($D_{50}$) of the lithium transition metal oxide in the single particle form may be in the range of 0.5 μm to 10.0 μm, and an average particle diameter ($D_{50}$) of the lithium transition metal oxide in the quasi-single particle form may be in the range of 3.0 μm to 15.0 μm.

The average particle diameter ($D_{50}$) of the lithium transition metal oxide in the quasi-single particle form may vary depending on the number and size of unit particles constituting the quasi-single particle.

The unit particles constituting the quasi-single particle may have a size corresponding to that of the lithium transition metal oxide in the single particle form. In other words, an average particle diameter ($D_{50}$) of the unit particles constituting the quasi-single particle may be in the range of 0.5 μm to 10.0 μm.

The lithium transition metal oxide having at least one form selected from the single particle form composed of one unit particle and the quasi-single particle form in which 30 or fewer unit particles are aggregated may have a larger average crystallite size than a multi-particle lithium transition metal oxide.

The average crystallite size may be calculated through Rietveld Refinement of an X-ray diffraction (XRD) spectrum obtained using Cu-Kα radiation, and an average crystallite size of the lithium transition metal oxide defined herein may be in the range of 160 nm to 200 nm.

The coating layer may be formed in an island form discontinuously occupying the surface of the lithium transition metal oxide.

According to another aspect of the present invention, there is provided a positive electrode comprising the above-described positive electrode active material.

According to still another aspect of the present invention, there is provided a lithium secondary battery comprising the above-described positive electrode.

According to the present invention, the lifetime characteristics and stability of a lithium secondary battery using the positive electrode active material defined herein can be improved by reducing the number of unit particles constituting a lithium transition metal oxide of a Mid-Ni type having a relatively low content of nickel (for example, about 70 mol% or less, or about 65 mol% or less).

According to the present invention, surface modification of a lithium transition metal oxide of a Mid-Ni type having a relatively low content of nickel (for example, about 70 mol% or less, or about 65 mol% or less) can reduce residual lithium on the surface and suppress surface side reactions between the lithium transition metal oxide and the electrolyte during charge and discharge, thereby suppressing and/or mitigating a swelling of the lithium secondary battery caused by gas generation.

In general, compared to a positive electrode active material including a High-Ni-type lithium transition metal oxide having a content of nickel exceeding 70 mol%, a positive electrode active material including a Mid-Ni-type lithium transition metal oxide having a relatively low content of nickel (for example, about 70 mol% or less, or about 65 mol% or less) may be less suitable for exhibiting appropriate driving characteristics under high-voltage operating conditions, because electrochemical properties related to the output of a lithium secondary battery, such as capacity characteristics and rate characteristics, tend to deteriorate.

In addition, as a content of manganese in the lithium transition metal oxide of a Mid-Ni type having a relatively low content of nickel becomes higher than a content of cobalt, kinetic properties such as lithium-ion conductivity tend to decrease, thereby deteriorating capacity and rate characteristics.

According to the present invention, by forming a tungsten-containing coating layer on the surface of the lithium transition metal oxide of a Mid-Ni type having a relatively low content of nickel (for example, about 70 mol% or less, or about 65 mol% or less) through low-temperature heat treatment, there can be provided a positive electrode active material exhibiting particularly improved discharge capacity and rate characteristics.

In addition to the above-described effects, specific effects of the present invention will be described in detail below together with detailed descriptions of embodiments for carrying out the invention.

BRIEF DESCRIPTION OF THE DRAWINGS

FIG. 1 is a surface SEM image of the positive electrode active material (lithium transition metal oxide) according to Example 1.

FIG. 2 is a surface SEM image of the positive electrode active material (lithium transition metal oxide) according to Example 2.

FIG. 3 is a surface SEM image of the positive electrode active material (lithium transition metal oxide) according to Example 3.

FIG. 4 is a surface SEM image of the positive electrode active material (lithium transition metal oxide) according to Example 4.

FIG. 5 is a surface SEM image of the positive electrode active material (lithium transition metal oxide) according to Comparative Example 1.

FIG. 6 is a surface SEM image of the positive electrode active material (lithium transition metal oxide) according to Comparative Example 2.

FIG. 7 is a surface SEM image of the positive electrode active material (lithium transition metal oxide) according to Comparative Example 3.

FIG. 8 is a surface SEM image of the positive electrode active material (lithium transition metal oxide) according to Comparative Example 4.

FIG. 9 is a surface SEM image of the positive electrode active material (lithium transition metal oxide) according to Comparative Example 5.

FIG. 10 is a surface SEM image of the positive electrode active material (lithium transition metal oxide) according to Comparative Example 6.

FIG. 11 is a cross-sectional SEM/EDS image of the positive electrode active material (lithium transition metal oxide) according to Example 2.

FIG. 12 is a cross-sectional SEM/EDS image of the positive electrode active material (lithium transition metal oxide) according to Example 3.

FIG. 13 is a surface SEM/EDS image of the positive electrode active material (lithium transition metal oxide) according to Example 2.

FIG. 14 is a surface SEM/EDS image of the positive electrode active material (lithium transition metal oxide) according to Comparative Example 2.

FIG. 15 is a cross-sectional SEM/EDS image of the positive electrode active material (lithium transition metal oxide) according to Comparative Example 3.

FIG. 16 is a cross-sectional SEM/EDS image of the positive electrode active material (lithium transition metal oxide) according to Comparative Example 4.

DETAILED DESCRIPTION OF EXEMPLARY EMBODIMENTS

To better understand the present invention, certain terms are defined herein for convenience. Unless otherwise defined herein, scientific and technical terms used herein will have meanings generally understood by those of ordinary skill in the art. In addition, unless the context clearly indicates otherwise, it should be understood that a term in the singular form also includes its plural form, and a term in the plural form also includes its singular form.

Positive electrode active material

A positive electrode active material according to one aspect of the present invention comprises a lithium transition metal oxide capable of reversible intercalation/deintercalation of lithium ions.

The lithium transition metal oxide is a composite metal oxide capable of intercalation/deintercalation of lithium ions, and has a layered crystal structure belonging to the R-3m space group. The lithium transition metal oxide having a layered crystal structure exhibits a characteristic peak in a region of 2θ of 18° to 20° in a diffraction pattern obtained from XRD analysis.

The lithium transition metal oxide comprises at least lithium and a transition metal. The transition metal may include at least one, at least two, or all of nickel, cobalt, and manganese.

Preferably, the lithium transition metal oxide may be a lithium nickel-based composite oxide containing nickel. In addition, the lithium transition metal oxide may be a lithium nickel-based composite oxide containing nickel and cobalt.

In order to improve low rate characteristics and lifespan characteristics while maintaining the high reversible capacity of $LiNiO_2$, the lithium nickel-based composite oxide may be a ternary lithium transition metal oxide such as NCM (Ni-Co-Mn) or NCA (Ni-Co-Al), in which a portion of nickel is substituted with cobalt, manganese, and/or aluminum, or a quaternary lithium transition metal oxide such as NCMA (Ni-Co-Mn-Al). The ternary or quaternary lithium transition metal oxide may further comprise dopants other than nickel, cobalt, manganese, and aluminum.

The lithium transition metal oxide may be a cobalt-free type lithium transition metal oxide in which the bulk particle does not contain cobalt. The cobalt-free type lithium transition metal oxide may further comprise dopants other than nickel, cobalt, and manganese.

The lithium transition metal oxide defined herein is a mid-Ni type lithium transition metal oxide having a relatively low nickel content. Herein, a lithium transition metal oxide having a nickel content among the transition metal of 70 mol% or less is referred to as a mid-Ni type lithium transition metal oxide, and a lithium transition metal oxide having a nickel content among the transition metal of more than 70 mol% is defined as a high-Ni type lithium transition metal oxide.

The content of nickel among the transition metal (the content of nickel relative to all elements other than lithium in the lithium transition metal oxide) may be 40 mol% or more and 70 mol% or less, 45 mol% or more and 70 mol% or less, 50 mol% or more and 70 mol% or less, 55 mol% or more and 65 mol% or less, or 60 mol% or more and 65 mol% or less.

When the content of nickel in the lithium transition metal oxide exceeds 70 mol%, cation mixing within the crystal structure may increase, resulting in reduced structural stability, or the amount of unreacted lithium impurities such as LiOH and $Li_2CO_3$ on the surface may increase. In particular, as the content of nickel in the lithium transition metal oxide increases, the stability of the material may sharply deteriorate under high-voltage operating conditions. On the other hand, when the content of nickel in the lithium transition metal oxide is less than 40 mol%, phase separation may occur due to an excessive amount of other transition metals (for example, manganese), thereby generating an impurity phase belonging to a crystal system other than the R-3m space group. Such an impurity phase may directly cause a deterioration in the electrochemical properties of the positive electrode active material.

The content of cobalt among the transition metal may be 10 mol% or less, 2.5 mol% or more and 10 mol% or less, or 5 mol% or more and 10 mol% or less.

If the content of cobalt in the lithium transition metal oxide exceeds 10 mol%, the goal of cost reduction of the positive electrode active material cannot be achieved. In addition, if the content of cobalt in the lithium transition metal oxide becomes excessively high, the operating voltage of a lithium secondary battery using the positive electrode active material may decrease, making it difficult to exhibit high output characteristics at relatively high voltages. Furthermore, if the content of cobalt in the lithium transition metal oxide becomes excessively high, the stability may be degraded due to an increase in the amount of gas generated in the lithium secondary battery using the positive electrode active material.

The lithium transition metal oxide may be a cobalt-free type lithium transition metal oxide that does not contain cobalt within the bulk particles; however, in order to facilitate smooth formation of a layered crystal structure belonging to the R-3m space group, it is preferable that a content of cobalt be at least 2.5 mol%.

The content of manganese among the transition metals may be in the range of 20 mol% to 50 mol%, 20 mol% to 45 mol%, 20 mol% to 40 mol%, 25 mol% to 35 mol%, or 27 mol% to 33 mol%. It is preferable that the difference between the content of manganese and the content of cobalt among the transition metals be 10 mol% or more.

When the content of manganese in the lithium transition metal oxide exceeds 50 mol%, the charge/discharge capacity and energy density of the positive electrode active material may decrease. In addition, since manganese is easily dissolved at high voltage, an excessively high content of manganese in the lithium transition metal oxide may increase the amount of manganese eluted from the positive electrode under high-voltage operating conditions, thereby causing long-term performance degradation or deterioration in lifetime characteristics of the lithium secondary battery.

Also, when the content of manganese in the lithium transition metal oxide exceeds 50 mol%, it may be difficult to form lithium transition metal oxides in the form of single particles and quasi-single particles, and excess manganese in the lithium transition metal oxide may cause phase separation, resulting in impurity phases belonging to space groups other than the R-3m space group. The impurity phases may directly affect the deterioration of the electrochemical characteristics of the positive electrode active material.

On the other hand, when the content of manganese in the lithium transition metal oxide is less than 20 mol%, the stability of the lithium transition metal oxide having a relatively low nickel content (for example, about 70 mol% or less, or about 65 mol% or less) as defined herein may decrease, and the operating voltage of a lithium secondary battery using the positive electrode active material may decrease, making it difficult to exhibit high output characteristics at relatively high voltages.

The lithium transition metal oxide may have a composition represented by Chemical Formula 1 below:

[Chemical Formula 1]  $Li_aNi_{1-(b+c+d)}Co_bMn_cM1_dO_2$

wherein,

in the above Chemical Formula 1,
M1 is at least one selected from Na, K, Mg, Ca, Sr, Ba, Rb, B, Ce, Hf, Ta, Cr, F, Al, V, Ti, Fe, Zr, Zn, Si, Y, Nb, Ga, Sn, Mo, W, P, Ge, Nd, Gd, and Cu; and
$0.95 \leq a \leq 1.15$, $0 \leq b \leq 0.10$, $0.20 \leq c \leq 0.50$, $0 \leq d \leq 0.10$, and $0.4 \leq 1-(b+c+d) \leq 0.7$.

In Chemical Formula 1, "a", representing the ratio of lithium to all elements other than lithium in the lithium transition metal oxide, may be 0.95 or more and 1.15 or less, 0.95 or more and 1.10 or less, 0.98 or more and 1.10 or less, or 1.01 or more and 1.07 or less.

When "a" in Chemical Formula 1 is less than 0.95, the capacity of the positive electrode active material containing the lithium transition metal oxide represented by Chemical Formula 1 may decrease. Conversely, when "a" in Chemical Formula 1 is greater than 1.15, phase separation may occur due to excess lithium and manganese present in the lithium transition metal oxide, resulting in impurity phases belonging to space groups other than the R-3m space group.

In Chemical Formula 1, "1-(b+c+d)", representing the ratio of nickel to all elements other than lithium in the lithium transition metal oxide, may be 0.40 or more and 0.70 or less, 0.45 or more and 0.70 or less, 0.50 or more and 0.70 or less, 0.55 or more and 0.65 or less, or 0.60 or more and 0.65 or less.

In Chemical Formula 1, "b", representing the ratio of cobalt to all elements other than lithium in the lithium transition metal oxide, may be 0 or more and 0.10 or less, 0.025 or more and 0.10 or less, or 0.05 or more and 0.10 or less.

In Chemical Formula 1, "c", representing the ratio of manganese to all elements other than lithium in the lithium transition metal oxide, may be 0.20 or more and 0.50 or less, 0.20 or more and 0.45 or less, 0.20 or more and 0.40 or less, 0.25 or more and 0.35 or less, or 0.27 or more and 0.33 or less.

In Chemical Formula 1, "M1" refers to dopants other than calcium that are doped into the lithium transition metal oxide. The lithium transition metal oxide has a layered crystal structure in which a lithium layer containing lithium and a transition metal layer containing a transition metal are alternately arranged, and the dopant may be present in a state doped into the crystal lattice of the lithium transition metal oxide (at least one of the lithium layer and/or the transition metal layer).

When the lithium transition metal oxide includes a dopant, d in Chemical Formula 1, which represents a molar ratio of the dopant to all elements other than lithium in the lithium transition metal oxide, is greater than 0.

When the lithium transition metal oxide includes a dopant, d in Chemical Formula 1, which represents a molar fraction of the dopant to all metallic elements other than lithium in the lithium transition metal oxide, may be 0.10 or less, 0.05 or less, 0.04 or less, 0.03 or less, 0.02 or less, or 0.01 or less.

As described later, a coating layer is present on the surface of the lithium transition metal oxide, and the coating layer includes tungsten. When tungsten contained in the coating layer formed on the surface of the lithium transition metal oxide diffuses into unit particles constituting the lithium transition metal oxide and is thereby doped, d in Chemical Formula 1, which represents a molar ratio of the dopant to all elements other than lithium in the lithium transition metal oxide, is greater than 0, and M1 includes tungsten.

When the lithium transition metal oxide selectively includes a dopant, the dopant may include at least one selected from Na, K, Mg, Ca, Sr, Ba, Rb, B, Ce, Hf, Ta, Cr, F, Al, V, Ti, Fe, Zr, Zn, Si, Y, Nb, Ga, Sn, Mo, W, P, Ge, Nd, Gd, and Cu; preferably at least one selected from Mg, Ca, Al, Ti, Zr, Mo, W, and P; and more preferably at least one selected from Ca, Al, Ti, W, and Zr.

The type, combination, and content of the dopant may be appropriately selected within a range that does not adversely affect the electrochemical properties and stability of the positive electrode active material.

The upper and lower limits of the contents (molar ratios) of nickel, cobalt, manganese, and the dopant defined in Chemical Formula 1 may be appropriately selected within the ranges satisfying the above-described definitions.

As described above, the lithium transition metal oxide further comprises cobalt and manganese as transition metals, and the content of manganese in the lithium transition metal oxide may be greater than the content of cobalt. However, in a conventional mid-Ni type lithium transition metal oxide, as the manganese content becomes higher than the cobalt content, kinetic characteristics such as lithium ion conductivity tend to decrease, resulting in deterioration of rate capability.

Accordingly, herein, in order to improve the efficiency of reversible intercalation/deintercalation of lithium ions by the lithium transition metal oxide and thereby enhance rate capability, the lithium transition metal oxide is characterized by having a small number of unit particles.

In addition, as the number of unit particles constituting the lithium transition metal oxide decreases, the specific surface area of the positive electrode active material including the lithium transition metal oxide is reduced, thereby decreasing surface side reactions between the lithium transition metal oxide and the electrolyte during charge and discharge, and consequently improving the lifetime characteristics of a lithium secondary battery using the positive electrode active material.

Specifically, the lithium transition metal oxide may have at least one form selected from a form of a single particle consisting of a single unit particle and a form of a quasi-single particle form in which 30 or less unit particles are aggregated. The term "unit particle" is defined as being equivalent to "primary particle."

The single unit particle may have a rod shape, an elliptical shape, and/or an irregular shape. In addition, unless specifically intended during the manufacturing process, variously shaped unit particles may exist within the same positive electrode active material. The term "unit particle" refers to a particle unit in which no apparent grain boundary is observed when observed under a scanning electron microscope (SEM) at a magnification of $5,000\times$ to $20,000\times$.

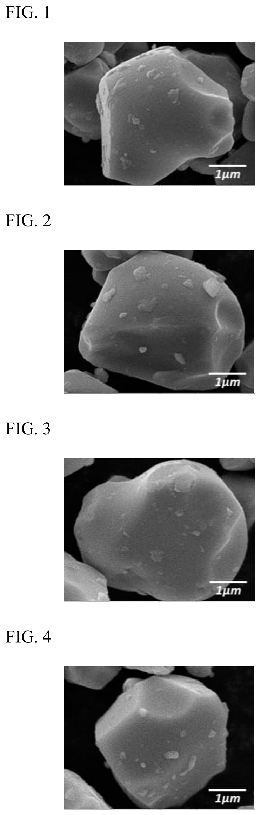

That is, the form of a single particle consisting of a single unit particle means that the lithium transition metal oxide is composed of only one unit particle, not a secondary particle formed by aggregation of multiple unit particles (see high-magnification SEM images of FIGS. 1 and 2). The average particle diameter ($D_{50}$) of the lithium transition metal oxide present in the form of a single particle may be 1.0 $\mu$m to 8.0 $\mu$m, 1.0 $\mu$m to 7.0 $\mu$m, 1.0 $\mu$m to 6.0 $\mu$m, 1.0 $\mu$m to 5.0 $\mu$m, 2.0 $\mu$m to 8.0 $\mu$m, 2.0 $\mu$m to 7.0 $\mu$m, 2.0 $\mu$m to 6.0 $\mu$m, or 2.0 $\mu$m to 5.0 $\mu$m.

The average particle diameter ($D_{50}$) of the unit particle may be the average of the length in the major axis direction and the length in the minor axis direction of the unit particle ([major axis length + minor axis length]/2). The average particle diameter of the unit particle may be calculated as the average value of the particle diameters of all unit particles observed from a surface SEM image and/or a cross-sectional SEM image of the lithium transition metal oxide.

When the average particle diameter of the unit particle is less than 1.0 $\mu$m, the lithium transition metal oxide is more likely to have a polycrystalline structure in which 50 or more, or 100 or more, unit particles are aggregated, instead of having a single particle form and/or a quasi-single particle form. In addition, when the average particle diameter of the unit particles is less than 1.0 $\mu$m, the specific surface area of the positive electrode active material including a lithium transition metal oxide having at least one form selected from a single particle form composed of one unit particle and a quasi-single particle form in which 30 or fewer unit particles are aggregated may increase, thereby causing a deterioration in stability due to side reactions with the electrolyte.

On the other hand, when the average particle diameter of the unit particles is greater than 8.0 $\mu$m, excessive grain growth of the unit particles may be induced, which may in turn reduce the lithium-ion diffusivity mediated through the unit particles. In addition, due to the characteristics of a Mid-Ni-type lithium transition metal oxide having a relatively high content of transition metals other than nickel, the distribution of transition metals within the unit particles may become non-uniform.

In general, ternary or quaternary type lithium transition metal oxides have a secondary particle form in which hundreds or thousands of unit particles are aggregated. The lithium transition metal oxide defined herein may have a secondary particle form in which a plurality of unit particles are aggregated; however, it has a quasi-single particle form in which 30 or fewer, 20 or fewer, or 10 or fewer unit particles are aggregated.

Hereinafter, in order to distinguish from a secondary particle in which hundreds or thousands of unit particles are aggregated, a secondary particle in which 30 or fewer, 20 or fewer, or 10 or fewer unit particles are aggregated may be referred to as a quasi-single particle. In addition, primary particles constituting a conventional secondary particle form of a ternary or quaternary type lithium transition metal oxide have a smaller particle diameter than the unit particles defined herein.

An average particle diameter ($D_{50}$) of the lithium transition metal oxide in the quasi-single particle form may be 3.0 $\mu$m or more and 12.0 $\mu$m or less, or 4.0 $\mu$m or more and 12.0 $\mu$m or less. The average particle diameter ($D_{50}$) of the lithium transition metal oxide in the quasi-single particle form may vary depending on the number and size of unit particles constituting the quasi-single particle.

In addition, the unit particles constituting the quasi-single particle may have a size corresponding to that of the lithium transition metal oxide in the single particle form. That is, an average particle diameter ($D_{50}$) of the unit particles constituting the quasi-single particle may be 1.0 $\mu$m or more and 8.0 $\mu$m or less, 1.0 $\mu$m or more and 7.0 $\mu$m or less, 1.0 $\mu$m or more and 6.0 $\mu$m or less, 1.0 $\mu$m or more and 5.0 $\mu$m or less, 2.0 $\mu$m or more and 8.0 $\mu$m or less, 2.0 $\mu$m or more and 7.0

μm or less, 2.0 μm or more and 6.0 μm or less, or 2.0 μm or more and 5.0 μm or less.

The average particle diameter ($D_{50}$) of the lithium transition metal oxide present in the form of a quasi-single particle form may be calculated as the average value of the particle diameters of the quasi-single particles observed in SEM images.

Herein, the term "particle size" is defined as being synonymously with "particle diameter" or "particle size" and, unless otherwise defined, all "average particle sizes" refer to the particle size corresponding to 50% of the cumulative volume determined by the above-described laser diffraction method.

A particle size distribution of the lithium transition metal oxide in the positive electrode active material may be measured using a laser diffraction method. For example, after dispersing the secondary particles in a dispersion medium, the particles may be introduced into a commercially available laser diffraction particle size analyzer (for example, Microtrac MT 3000), irradiated with ultrasonic waves at about 28 kHz with an output of 60 W, and then a volume cumulative particle size distribution graph may be obtained, wherein the particle size corresponding to 50% of the cumulative volume may be defined as the average particle diameter ($D_{50}$).

The positive electrode active material may include both a lithium transition metal oxide in a single particle form and a lithium transition metal oxide in a quasi-single particle form.

The $D_{50}$ measured by the laser diffraction method for the positive electrode active material including the lithium transition metal oxide in the single particle form and the quasi-single particle form may be 1.0 μm or more and 12.0 μm or less, 1.0 μm or more and 10.0 μm or less, 1.0 μm or more and 8.0 μm or less, 1.0 μm or more and 7.0 μm or less, 2.0 μm or more and 8.0 μm or less, 2.0 μm or more and 7.0 μm or less, 2.0 μm or more and 6.0 μm or less, 2.5 μm or more and 5.5 μm or less, or 2.7 μm or more and 5.4 μm or less.

A positive electrode active material including a Mid-Ni-type lithium transition metal oxide having a content of nickel of 40 mol% or more and 70 mol% or less may exhibit an optimal energy density per unit volume within the above $D_{50}$ range.

In general, compared to a positive electrode active material including a High-Ni-type lithium transition metal oxide having a content of nickel exceeding 70 mol%, a positive electrode active material including a Mid-Ni-type lithium transition metal oxide having a relatively low content of nickel (for example, about 70 mol% or less, or about 65 mol% or less) may be less suitable for exhibiting appropriate driving characteristics under high-voltage operating conditions, because electrochemical properties related to the output of a lithium secondary battery, such as capacity characteristics and rate characteristics, tend to deteriorate.

In addition, as a content of manganese in a Mid-Ni-type lithium transition metal oxide having a relatively low content of nickel becomes greater than a content of cobalt, kinetic properties such as lithium-ion conductivity tend to decrease, thereby deteriorating capacity and rate characteristics.

Accordingly, according to the present invention, a tungsten-containing coating layer may be formed on the surface of a Mid-Ni-type lithium transition metal oxide having a relatively low content of nickel (for example, about 70 mol% or less, or about 65 mol% or less) through surface modification, thereby improving discharge capacity and rate characteristics.

According to the present invention, surface modification of a Mid-Ni-type lithium transition metal oxide having a relatively low content of nickel (for example, about 70 mol% or less, or about 65 mol% or less) can also reduce residual lithium on the surface and suppress surface side reactions between the lithium transition metal oxide and the electrolyte during charge and discharge, thereby suppressing and/or alleviating a swelling phenomenon of the lithium secondary battery caused by gas generation.

The tungsten-containing coating layer may include a lithium-tungsten oxide represented by Chemical Formula 2 below:

$$[\text{Chemical Formula 2}] \qquad Li_e W_f O_g$$

In Chemical Formula 2, $0 < e \le 8$, $0 < f \le 15$, and $0 < g \le 20$, and e, f, and g represent numbers determined from a stoichiometric ratio according to the valence and equivalent of tungsten.

Non-limiting examples of the lithium-tungsten-containing oxide include $LiWO_3$, $Li_2WO_4$, $Li_3WO_4$, $Li_3WO_6$, $Li_4WO_5$, $Li_6WO_6$, and $Li_8WO_6$

The tungsten-containing coating layer may be formed by heat-treating a mixture of a tungsten-containing raw material, such as $WO_3$ or $W_2O_5$, and the lithium transition metal oxide, such that residual lithium present on the surface of the lithium transition metal oxide reacts with the tungsten-containing raw material.

When the heat-treatment temperature of a mixture of a Mid-Ni-type lithium transition metal oxide having a relatively low content of nickel (for example, about 70 mol% or less, or about 65 mol% or less) and a tungsten-containing raw material is excessively high (for example, 500°C or more), tungsten contained in the tungsten-containing raw material may diffuse into and be doped into the lithium transition metal oxide, making it difficult to form a tungsten-containing coating layer on the surface of the lithium transition metal oxide.

On the other hand, when the heat-treatment temperature of the mixture of the Mid-Ni-type lithium transition metal oxide having a relatively low content of nickel (for example, about 70 mol% or less, or about 65 mol% or less) and the tungsten-containing raw material is excessively low (for example, less than 300°C), the tungsten-containing raw material may not sufficiently react with residual lithium present on the surface of the lithium transition metal oxide, resulting in an insufficient reduction of surface residual lithium and the presence of the tungsten-containing raw material as an impurity on the surface.

A content of tungsten, calculated based on all metallic elements other than lithium present in the positive electrode active material, may be greater than 0.1 mol% and less than 0.5 mol%, 0.15 mol% or more and 0.45 mol% or less, 0.2 mol% or more and 0.4 mol% or less, or 0.2 mol% or more and 0.3 mol% or less.

The content of tungsten present in the tungsten-containing coating layer may be calculated through inductively coupled plasma (ICP) analysis of the positive electrode active material.

Specifically, the ICP analysis method is a method of measuring the content of elements contained in the positive electrode active material by using an inductively coupled plasma spectrometer (ICP) according to a known procedure. The content of tungsten measured by the ICP analysis reflects the designed composition, i.e., the amount of tungsten used in the manufacturing process of the positive electrode active material, even when taking measurement errors into consideration.

When the content of tungsten, calculated based on all metallic elements other than lithium present in the positive electrode active material, is 0.1 mol% or less, the effect of reducing surface residual lithium may be insufficient, and a tungsten-containing coating layer may not be sufficiently formed on the surface. As a result, the improvement in capacity characteristics and rate characteristics of a Mid-Ni-type lithium transition metal oxide having a relatively low content of nickel (for example, about 70 mol% or less, or about 65 mol% or less) may also be insufficient.

On the other hand, when the content of tungsten, calculated based on all metallic elements other than lithium present in the positive electrode active material, is 0.5 mol% or more, the surface kinetic properties of a Mid-Ni-type lithium transition metal oxide having a relatively low content of nickel (for example, about 70 mol% or less, or about 65 mol% or less) may be altered. For example, the ionic conductivity or electronic conductivity of the lithium transition metal oxide may decrease, and the interaction between the lithium transition metal oxide and the electrolyte may be suppressed, making sufficient activation during initial charging difficult.

The coating layer may be formed continuously and/or discontinuously on the surface of the lithium transition metal oxide. For example, the coating layer may be formed in an island form discontinuously occupying the surface of the lithium transition metal oxide.

When the lithium transition metal oxide has a secondary particle form in which at least two unit particles are aggregated, the coating layer may be formed in a gap between adjacent unit particles and/or at a grain boundary corresponding to a contact surface between adjacent unit particles.

The presence of the coating layer in the gap between adjacent unit particles means that the oxide and/or lithium composite oxide constituting the coating layer exists in a form filling the gap between the adjacent unit particles.

In addition, when the lithium transition metal oxide has a secondary particle form in which at least two unit particles are aggregated, the coating layer may diffuse along a gap between adjacent unit particles and/or along a grain boundary corresponding to a contact surface between adjacent unit particles in a direction from the surface of the secondary particle toward the center thereof. At this time, tungsten contained in the coating layer may exhibit a concentration gradient decreasing in the direction from the surface of the secondary particle toward the center thereof.

Meanwhile, in the Mid-Ni-type lithium transition metal oxide defined herein, which has a relatively low content of nickel (for example, about 70 mol% or less, or about 65 mol% or less) and a higher content of manganese than cobalt (in particular, a difference between the content of manganese and the content of cobalt among the transition metals being 10 mol% or more), lattice strain may increase as the distribution of transition metals in the composition becomes non-uniform or as the stability of the crystal structure decreases.

As the stability of the crystal structure of the lithium transition metal oxide decreases, the size of crystallites constituting the lithium transition metal oxide or the distance between adjacent crystallites may become irregular. The lattice strain is one of the indices representing the regularity of the crystallites, and the lattice strain may increase as the irregularity of the crystallites increases.

For example, when the heat-treatment temperature of a mixture of a Mid-Ni-type lithium transition metal oxide having a relatively low content of nickel (for example, about 70 mol% or less, or about 65 mol% or less) and a tungsten-containing raw material is excessively high (for example, 500°C or more), the lattice strain may increase as tungsten contained in the tungsten-containing raw material diffuses into and is doped into the lithium transition metal oxide.

The lattice strain ($\varepsilon$) may be calculated from an X-ray diffraction (XRD) spectrum obtained by using Cu-K$\alpha$ radiation for the positive electrode active material through various known methods. For example, the lattice strain ($\varepsilon$) may be calculated by Rietveld Refinement or by the Williamson-Hall method using an XRD spectrum obtained by using Cu-K$\alpha$ radiation for the positive electrode active material.

The lattice strain is expressed as $\Delta d/d$, and as the lattice strain ($\varepsilon$) increases, atomic displacements are induced, leading to broadening of diffraction peaks.

The Williamson-Hall method proposes a technique for extracting information on crystallite size and lattice strain from the integral breadth of diffraction peaks.

The lattice strain ($\varepsilon$), expressed as $\Delta d/d$, may be represented as one-fourth of the slope of a straight line obtained by plotting $\beta\cos\theta$ against $\sin\theta$ on a coordinate plane in which the horizontal axis represents $\sin\theta$ and the vertical axis represents $\beta\cos\theta$ in a diffraction angle ($\theta$) range of $2\theta = 10°$ to $120°$ (or may be expressed as $\beta/4\tan\theta$).

In addition, the lattice strain ($\varepsilon$) may be calculated by the equation below:

$$\beta\cos\theta = 4\varepsilon\sin\theta + 0.9\lambda/D$$

In this equation, $\beta$ denotes the full width at half maximum (FWHM), $\theta$ denotes the diffraction angle, $\lambda$ denotes the wavelength (Å) of the X-ray used for the XRD analysis, and D denotes the crystallite size of the lithium transition metal oxide. The lattice strain ($\varepsilon$) may be calculated from the intercept and slope of a straight line obtained by plotting the values calculated from the above equation.

The lattice strain of a Mid-Ni-type lithium transition metal oxide defined herein, which has a relatively low content of nickel (for example, about 70 mol% or less, or about 65 mol% or less) and a higher content of manganese than cobalt, may be reduced through surface modification performed under predetermined conditions.

The lattice strain ($\varepsilon$) calculated by Rietveld Refinement of an X-ray diffraction (XRD) spectrum obtained using Cu-K$\alpha$ radiation for the positive electrode active material including the Mid-Ni-type lithium transition metal oxide defined herein, which has a relatively low content of nickel (for example, about 70 mol% or less, or about 65 mol% or less) and a higher content of manganese than cobalt, is preferably 0.00025 or less.

In addition, the average crystallite size of the lithium transition metal oxide calculated by the aforementioned method may be 160 nm to 200 nm.

When the average crystallite size is less than 160 nm or greater than 200 nm, the improvement in electrochemical characteristics such as capacity and rate performance of a lithium secondary battery using the lithium transition metal oxide as a positive electrode active material may be insignificant.

If the growth of unit particles constituting the lithium transition metal oxide is insufficient, the average crystallite size may be less than 160 nm. When the average crystallite size exceeds 200 nm, resistance may increase, resulting in polarization behavior, and cracks may occur within particles due to such polarization, which may eventually cause a decrease in the lifetime of the positive electrode active material.

The average nickel (Ni) occupancy in the Li 3a site, calculated by Rietveld Refinement of an X-ray diffraction (XRD) spectrum obtained using Cu-K$\alpha$ radiation for the positive electrode active material, may be less than 3.5%, 3.4% or less, 3.35% or less, or 3.34% or less.

Herein, the average nickel (Ni) occupancy in the Li 3a site may vary depending on the growth of unit particles constituting the lithium transition metal oxide or as a result of surface modification thereof. The average nickel (Ni) occupancy in the Li 3a site serves as an indicator representing the degree of cation mixing between the lithium layer and the transition metal layer (i.e., between lithium and nickel), and as the average Ni occupancy in the Li 3a site increases, the lattice strain may also increase.

Lithium secondary battery

According to another aspect of the present invention, there is provided a positive electrode including a positive electrode current collector and a positive electrode active material layer formed on the positive electrode current collector. The positive electrode active material layer may include the positive electrode active material according to various embodiments of the present invention. Since the positive electrode active material is the same as described above, for convenience, a detailed explanation will be omitted, and only the components that have not been described will be described below.

The positive electrode current collector is not particularly limited as long as it does not cause a chemical change in a battery and has conductivity, and for example, stainless steel, aluminum, nickel, titanium, calcined carbon, or aluminum or stainless steel whose surface is treated with carbon, nickel, titanium or silver may be used. In addition, the positive electrode current collector may generally have a thickness of 3 $\mu$m to 500 $\mu$m, and fine irregularities may be formed on the surface of the current collector, thereby increasing the adhesion of a positive electrode active material. For example, the positive electrode current collector may be used in various forms such as a film, a sheet, a foil, a net, a porous body, a foam, a non-woven fabric, etc.

The positive electrode active material layer may be prepared by coating the positive electrode current collector with a positive electrode slurry composition including the positive electrode active material, a conductive material, and optionally a binder.

The positive electrode active material may be included in an amount of 80 wt% to 99 wt%, specifically 85 wt% to 98.5 wt%, with respect to the total weight of the positive electrode active material layer. When the positive electrode active material is included in this content range, excellent capacity characteristics may be exhibited, but the present invention is not necessarily limited thereto.

The conductive material is used to impart conductivity to an electrode, and is not particularly limited as long as it has electron conductivity without causing a chemical change in a battery. Specific examples of the conductive material may include graphite such as natural graphite or artificial graphite; a carbon-based material such as carbon black, acetylene black, Ketjen black, channel black, furnace black, lamp black, thermal black or a carbon fiber; a metal powder or metal fiber consisting of copper, nickel, aluminum, or silver; a conductive whisker consisting of zinc oxide or potassium titanate; a conductive metal oxide such as titanium oxide; or a conductive polymer such as a polyphenylene derivative, and one or a mixture of two or more thereof may be used. The conductive material may be included in an amount of 0.1 wt% to 15 wt% with respect to the total weight of the positive electrode active material layer.

The binder serves to improve the adhesion between particles of the positive electrode active material and the adhesion between the positive electrode active material and a current collector. Specific examples of the binder may include polyvinylidene fluoride (PVDF), a vinylidene fluoride-hexafluoropropylene copolymer (PVDF-co-HFP), polyvinyl alcohol, polyacrylonitrile, carboxymethylcellulose (CMC), starch, hydroxypropyl cellulose, regenerated cellulose, polyvinylpyrrolidone, tetrafluoroethylene, polyethylene, polypropylene, an ethylene-propylene-diene polymer (EPDM), a sulfonated EPDM, styrene butadiene rubber (SBR), a fluoroelastomer, or various copolymers thereof, and one or a mixture of two or more thereof may be used. The binder may be included in an amount of 0.1 wt% to 15 wt% with respect to the total weight of the positive electrode active material layer.

The positive electrode may be manufactured according to a conventional method of manufacturing a positive electrode, except that the above-described positive electrode active material is used. Specifically, the positive electrode may be manufactured by coating the positive electrode current collector with a positive electrode slurry composition prepared by dissolving or dispersing the positive electrode active material, and optionally, a binder and a conductive material in a solvent, and drying and rolling the resulting product.

The solvent may be a solvent generally used in the art, and may be dimethyl sulfoxide (DMSO), isopropyl alcohol, N-methylpyrrolidone (NMP), acetone or water, and one or a mixture of two or more thereof may be used. In consideration of the coating thickness and production yield of a slurry, the solvent is used at a sufficient amount for dissolving or dispersing the positive electrode active material, the conductive material, and the binder and then imparting a viscosity for exhibiting excellent thickness uniformity when the slurry is applied to manufacture a positive electrode.

In addition, in another embodiment, the positive electrode may be manufactured by casting the positive electrode slurry composition onto a separate support, and then laminating a film obtained by delamination from the support onto the positive electrode current collector.

Moreover, still another aspect of the present invention provides an electrochemical device including the above-described positive electrode. The electrochemical device may be, specifically, a battery, a capacitor, and more specifically, a lithium secondary battery.

The lithium secondary battery may specifically include a positive electrode, a negative electrode disposed opposite to the positive electrode, and a separator, which is interposed between the positive electrode and the negative electrode, and an electrolyte. Since the positive electrode is the same as described above, detailed description of the positive electrode will be omitted for convenience, and other components which have not been described above will be described in detail below.

The lithium secondary battery may further optionally include a battery case accommodating an electrode assembly of the positive electrode, the negative electrode and the separator, and a sealing member for sealing the battery case.

The negative electrode may include a negative electrode current collector and a negative electrode active material layer disposed on the negative electrode current collector.

The negative electrode current collector is not particularly limited as long as it has high conductivity without causing a chemical change in a battery, and may be, for example, copper, stainless steel, aluminum, nickel, titanium, calcined carbon, or copper or stainless steel whose surface is treated with carbon, nickel, titanium or silver, or an aluminum-cadmium alloy. In addition, the negative electrode current collector may generally have a thickness of 3 $\mu$m to 500 $\mu$m, and like the positive electrode current collector, fine irregularities may be formed on the current collector surface, thereby enhancing the binding strength of the negative electrode active material. For example, the negative electrode current collector may be used in various forms such as a film, a sheet, a foil, a net, a porous body, a foam, a non-woven fabric, etc.

The negative electrode active material layer may be formed by coating the negative electrode current collector with a negative electrode slurry composition including the negative electrode active material, a conductive material, and optionally a binder.

As the negative electrode active material, a compound capable of the reversible intercalation/deintercalation of

EP 4 745 091 A1

lithium may be used. Specific examples of the negative electrode active material may include a carbonaceous material such as artificial graphite, natural graphite, graphitized carbon fiber or amorphous carbon; a metallic compound capable of alloying with lithium, such as Si, Al, Sn, Pb, Zn, Bi, In, Mg, Ga, Cd, a Si alloy, a Sn alloy or an Al alloy; a metal oxide capable of doping and dedoping lithium such as $SiO_\beta$ ($0<\beta<2$), $SnO_2$, vanadium oxide, or lithium vanadium oxide; or a composite including the metallic compound and the carbonaceous material such as a Si-C composite or a Sn-C composite, and any one or a mixture of two or more thereof may be used. As the negative electrode active material, a metal lithium thin film may be used. In addition, as a carbon material, both low-crystalline carbon and high-crystalline carbon may be used. Representative examples of the low-crystalline carbon include soft carbon and hard carbon, and representative examples of the high-crystalline carbon include amorphous, plate-like, flaky, spherical or fiber-like natural or artificial graphite, Kish graphite, pyrolytic carbon, mesophase pitch-based carbon fiber, meso-carbon microbeads, mesophase pitches, and high-temperature calcined carbon such as petroleum or coal tar pitch derived cokes.

The negative electrode active material may be included in an amount of 80 wt% to 99 wt% with respect to the total weight of the negative electrode active material layer.

The binder is a component that assists in the bonding between a conductive material, an active material, and a current collector, and may typically be added in an amount of 0.1 wt% to 10 wt% with respect to the total weight of the negative electrode active material layer. Examples of the binder may include polyvinylidene fluoride (PVDF), polyvinyl alcohol, carboxymethylcellulose (CMC), starch, hydroxypropylcellulose, regenerated cellulose, polyvinylpyrrolidone, tetrafluoroethylene, polyethylene, polypropylene, an ethylene-propylene-diene polymer (EPDM), a sulfonated-EPDM, styrene-butadiene rubber, nitrile-butadiene rubber, a fluoroelastomer, and various copolymers thereof.

The conductive material is a component for further improving the conductivity of the negative electrode active material, and may be added in an amount of 10 wt% or less, preferably, 5 wt% or less, with respect to the total weight of the negative electrode active material layer. The conductive material is not particularly limited as long as it does not cause a chemical change in the battery and has conductivity, and may be, for example, graphite such as natural graphite or artificial graphite; carbon black such as acetylene black, Ketjen black, channel black, furnace black, lamp black, or thermal black; a conductive fiber such as a carbon fiber or a metal fiber; a metal powder such as fluorinated carbon, aluminum, or nickel powder; a conductive whisker consisting of zinc oxide or potassium titanate; a conductive metal oxide such as titanium oxide; or a conductive material such as a polyphenylene derivative.

In an embodiment, the negative electrode active material layer may be prepared by coating the negative electrode current collector with a negative electrode slurry composition prepared by dissolving or dispersing a negative electrode active material, and optionally, a binder and a conductive material in a solvent, and then drying, or may be prepared by casting the negative electrode slurry composition on a separate support and then laminating a film delaminated from the support on the negative electrode current collector.

Meanwhile, in the lithium secondary battery, the separator separates the negative electrode and the positive electrode and provides a passage for lithium ions to move, and is not particularly limited as long as it is commonly used as a separator in lithium secondary batteries. In particular, it is preferable that the separator has low resistance to ion transfer of the electrolyte and excellent electrolyte impregnation ability. Specifically, a porous polymer film, such as a porous polymer film made of a polyolefin-based polymer such as an ethylene homopolymer, a propylene homopolymer, an ethylene/-butene copolymer, an ethylene/hexene copolymer, and an ethylene/methacrylate copolymer, or a stacked structure including two or more layers thereof may be used. In addition, a conventional porous non-woven fabric, such as a non-woven fabric made of high melting point glass fiber or polyethylene terephthalate fiber, may be used. In addition, a coated separator including a ceramic component or a polymer material may be used to ensure thermal resistance or mechanical strength, and may be optionally used in a single- or multi-layered structure.

In addition, the electrolyte used herein may be an organic liquid electrolyte, an inorganic liquid electrolyte, a solid polymer electrolyte, a gel-type polymer electrolyte, a solid inorganic electrolyte, or a molten-type inorganic electrolyte, which is able to be used in manufacturing lithium secondary batteries, but the present invention is not limited thereto.

Specifically, the electrolyte may include an organic solvent and a lithium salt.

The organic solvent is not particularly limited as long as it can serve as a medium enabling the movement of ions involved in an electrochemical reaction of a battery. Specifically, the organic solvent may be an ester-based solvent such as methyl acetate, ethyl acetate, $\gamma$-butyrolactone, or $\varepsilon$-caprolactone; an ether-based solvent such as dibutyl ether or tetrahydrofuran; a ketone-based solvent such as cyclohexanone; an aromatic hydrocarbon-based solvent such as benzene or fluorobenzene; a carbonate-based solvent such as dimethyl carbonate (DMC), diethyl carbonate (DEC), methyl ethyl carbonate (MEC), ethyl methyl carbonate (EMC), ethylene carbonate (EC), or propylene carbonate (PC); an alcohol-based solvent such as ethyl alcohol or isopropyl alcohol; a nitrile-based solvent such as R-CN (R is a linear, branched or cyclic $C_2$ to $C_{20}$ hydrocarbon group, and may include a double bonded aromatic ring or an ether bond); an amide-based solvent such as dimethylformamide; a dioxolane-based solvent such as 1,3-dioxolane; or a sulfolane-based solvent. Among these, a carbonate-based solvent is preferred, and a mixture of a cyclic carbonate (such as ethylene carbonate or propylene carbonate), which has high ionic conductivity and a high dielectric constant that can improve the charging/discharging performance of the battery and a low-viscosity linear carbonate-based compound (such as ethyl methyl carbonate, dimethyl carbonate, or diethyl carbonate) is more preferred. In this case, it is preferable to use a mixture of cyclic carbonate and chain-type carbonate at a volume ratio of about 1:1 to about 1:9, which can result in excellent electrolyte performance.

The lithium salt is not particularly limited as long as it is a compound capable of providing lithium ions used in a lithium secondary battery. Specifically, the lithium salt may be $LiPF_6$, $LiClO_4$, $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, LiCl, LiI, or $LiB(C_2O_4)_2$. The concentration of the lithium salt is preferably in the range of 0.1 M to 2.0 M. When the concentration of the lithium salt is within this range, the electrolyte has appropriate conductivity and viscosity, exhibiting excellent electrolyte performance, and thus lithium ions may move effectively.

When the electrolyte used herein is a solid electrolyte, for example, a solid inorganic electrolyte such as a sulfide-based solid electrolyte, an oxide-based solid electrolyte, a nitride-based solid electrolyte, or a halide-based solid electrolyte may be used, and preferably, a sulfide-based solid electrolyte may be used.

As a material for the sulfide-based solid electrolyte, a solid electrolyte containing Li, an X element (where X is at least one selected from P, As, Sb, Si, Ge, Sn, B, Al, Ga, and In) and S may be used. Examples of the sulfide-based solid electrolyte material may include $Li_2S-P_2S_5$, $Li_2S-P_2S-LiX$ (where X is a halogen element such as I or Cl), $Li_2S-P_2S_5-Li_2O$, $Li_2S-P_2S_5-Li_2O-LiI$, $Li_2S-SiS_2$, $Li_2S-SiS_2-LiI$, $Li_2S-SiS_2-LiBr$, $Li_2S-SiS_2-LiCl$, $Li_2S-SiS_2-B_2S_3-LiI$, $Li_2S-SiS_2-P_2S_5-LiI$, $Li_2S-B_2S_3$, $Li_2S-P_2S_S-Z_mS_n$ (where m and n are integers, and Z is Ge, Zn, or Ga), $Li_2S-GeS_2$, $Li_2S-SiS_2-Li_3PO_4$, and $Li_2S-SiS_2-Li_pMO_q$ (where p and q are integers, and M is P, Si, Ge, B, Al, Ga, or In).

The solid electrolyte, preferably, the sulfide-based solid electrolyte, may be amorphous, crystalline, or in a state in which an amorphous phase and crystalline phase are mixed.

Materials for the oxide-based solid electrolyte include $Li_7La_3Zr_2O_{12}$, $Li_{7-x}La_3Zr_{1-x}Nb_xO_{12}$, $Li_{7-3x}La_3Zr_2Al_xO_{12}$, $Li_{3x}La_{2/3-x}TiO_3$, $Li_{1+x}Al_xTi_{2-x}(PO_4)_3$, $Li_{1+x}Al_xGe_{2-x}(PO_4)_3$, $Li_3PO_4$, $Li_{3+x}PO_{4-x}N_x$ (LiPON), and $Li_{2+2x}Zn_{1-x}GeO_4$ (LISICON).

The above-described solid electrolyte may be disposed as a separate layer (solid electrolyte layer) between the positive and negative electrodes. In addition, the solid electrolyte may be partially included in the positive electrode active material layer of the positive electrode independent of the solid electrolyte layer, or the solid electrolyte may be partially included in the negative electrode active material layer of the negative electrode independent of the solid electrolyte layer.

To enhance the lifetime characteristics of the battery, inhibit a decrease in battery capacity, and enhance the discharge capacity of the battery, the electrolyte may further include one or more types of additives, for example, a haloalkylene carbonate-based compound such as difluoroethylene carbonate, pyridine, triethylphosphite, triethanolamine, cyclic ether, ethylene diamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol or aluminum trichloride, in addition to the components of the electrolyte. The additive may be included in an amount of 0.1 wt% to 5 wt% with respect to the total weight of the electrolyte.

Since the lithium secondary battery including the positive electrode active material according to the present invention stably exhibits excellent discharge capacity, output characteristics, and lifetime characteristics, it is useful in portable devices such as mobile phones, laptop computers, and digital cameras and electric vehicles such as hybrid electric vehicles (HEVs).

The outer shape of the lithium secondary battery according to the present invention is not particularly limited, and may be a cylindrical, prismatic, pouch or coin shape using a can. In addition, the lithium secondary battery may be used not only in battery cells used as a power source of small devices, but also preferably used as a unit battery in medium and large-sized battery modules including a plurality of battery cells.

According to yet another aspect of the present invention, there is provided a battery module including the lithium secondary battery as a unit cell and/or a battery pack including the same.

The battery module or the battery pack may be used as a power source for any one or more of medium and large-sized devices such as a power tool; an electric vehicle including an electric vehicle (EV), a hybrid electric vehicle, and a plug-in hybrid electric vehicle (PHEV); and a power storage system.

Hereinafter, the present invention will be described in more detail through examples. However, these examples are only for the purpose of illustrating the present invention and should not be construed as limiting the scope of the present invention.

Preparation Example 1. Preparation of positive electrode active material

Example 1

A hydroxide precursor of $Ni_{0.62}Co_{0.07}Mn_{0.31}(OH)_2$ synthesized by a coprecipitation reaction was mixed with LiOH (Li/(Ni+Co+Mn) molar ratio = 1.04), and the mixture was heat-treated in a furnace at 950°C for 10 hours in an air atmosphere to obtain an intermediate product (lithium transition metal oxide).

Subsequently, the intermediate product was mixed with $WO_3$ (weighed so that the content of tungsten was 0.3 mol% based on the total transition metals in the intermediate product), and the mixture was heat-treated in a furnace at 350°C for 8 hours in an air atmosphere to obtain a final product having a tungsten-containing coating layer formed on the surface of the lithium transition metal oxide.

As confirmed from the surface SEM image of FIG. 1, the positive electrode active material according to Example 1 included lithium transition metal oxides in both single particle and quasi-single particle forms. According to the ICP analysis result of the final product, the content of tungsten in the final product was found to be consistent with the designed composition.

Example 2

A positive electrode active material was prepared in the same manner as in Example 1, except that the heat-treatment temperature of the mixture of the intermediate product and $WO_3$ was changed to 375 °C.

As confirmed from the surface SEM image of FIG. 2, the positive electrode active material according to Example 2 included lithium transition metal oxides in both single particle and quasi-single particle forms. According to the ICP analysis result of the final product, the content of tungsten in the final product was found to be consistent with the designed composition.

Example 3

A positive electrode active material was prepared in the same manner as in Example 1, except that the heat-treatment temperature of the mixture of the intermediate product and $WO_3$ was changed to 400 °C.

As confirmed from the surface SEM image of FIG. 3, the positive electrode active material according to Example 3 included lithium transition metal oxides in both single particle and quasi-single particle forms. According to the ICP analysis result of the final product, the content of tungsten in the final product was found to be consistent with the designed composition.

Example 4

A positive electrode active material was prepared in the same manner as in Example 1, except that the intermediate product and $WO_3$ were mixed such that the content of tungsten was 0.2 mol% based on the total transition metals in the intermediate product.

As confirmed from the surface SEM image of FIG. 4, the positive electrode active material according to Example 4 included lithium transition metal oxides in both single particle and quasi-single particle forms. According to the ICP analysis result of the final product, the content of tungsten in the final product was found to be consistent with the designed composition.

Comparative Example 1

A hydroxide precursor of $Ni_{0.62}Co_{0.07}Mn_{0.31}(OH)_2$ synthesized by a coprecipitation reaction was mixed with LiOH (Li/(Ni+Co+Mn) molar ratio = 1.04), and the mixture was heat-treated in a furnace at 950°C for 10 hours in an air atmosphere to obtain a final product (lithium transition metal oxide).

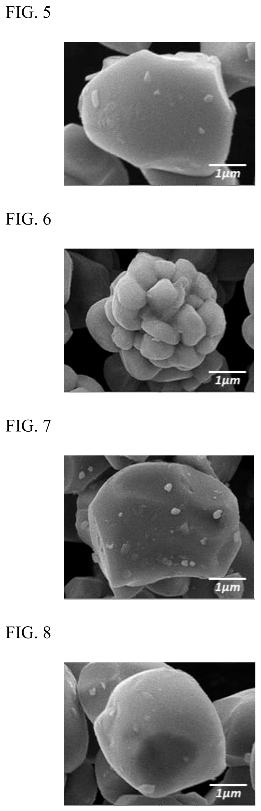

As confirmed from the surface SEM image of FIG. 5, the positive electrode active material according to Comparative Example 1 included lithium transition metal oxides in both single particle and quasi-single particle forms.

Comparative Example 2

A hydroxide precursor of $Ni_{0.62}Co_{0.07}Mn_{0.31}(OH)_2$ synthesized by a coprecipitation reaction was mixed with LiOH (Li/(Ni+Co+Mn) molar ratio = 1.04), and the mixture was heat-treated in a furnace at 850°C for 10 hours in an air atmosphere to obtain an intermediate product (lithium transition metal oxide).

Subsequently, the intermediate product was mixed with $WO_3$ (weighed so that the content of tungsten was 0.3 mol% based on the total transition metals in the intermediate product), and the mixture was heat-treated in a furnace at 375°C for 8 hours in an air atmosphere to obtain a final product having a tungsten-containing coating layer formed on the surface of the lithium transition metal oxide.

As confirmed from the surface SEM image of FIG. 6, the positive electrode active material according to Comparative Example 2 included lithium transition metal oxides in a multi-particle form composed of more than 30 unit particles. According to the ICP analysis result of the final product, the content of tungsten in the final product was found to be consistent with the designed composition.

Comparative Example 3

A positive electrode active material was prepared in the same manner as in Example 1, except that the heat-treatment temperature of the mixture of the intermediate product and $WO_3$ was changed to 250 °C.

As confirmed from the surface SEM image of FIG. 7, the positive electrode active material according to Comparative Example 3 included lithium transition metal oxides in both single particle and quasi-single particle forms. According to the ICP analysis result of the final product, the content of tungsten in the final product was found to be consistent with the designed composition.

Comparative Example 4

A positive electrode active material was prepared in the same manner as in Example 1, except that the heat-treatment temperature of the mixture of the intermediate product and $WO_3$ was changed to 650 °C.

As confirmed from the surface SEM image of FIG. 8, the positive electrode active material according to Comparative Example 4 included lithium transition metal oxides in both single particle and quasi-single particle forms. According to the ICP analysis result of the final product, the content of tungsten in the final product was found to be consistent with the designed composition.

Comparative Example 5

A positive electrode active material was prepared in the same manner as in Example 1, except that the intermediate product and $WO_3$ were mixed such that the content of tungsten was 0.1 mol% based on the total transition metals in the intermediate product.

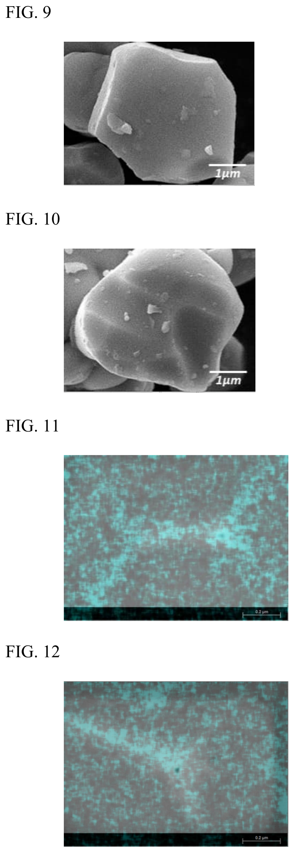

As confirmed from the surface SEM image of FIG. 9, the positive electrode active material according to Comparative Example 5 included lithium transition metal oxides in both single particle and quasi-single particle forms. According to the ICP analysis result of the final product, the content of tungsten in the final product was found to be consistent with the designed composition.

Comparative Example 6

A positive electrode active material was prepared in the same manner as in Example 1, except that the intermediate product and $WO_3$ were mixed such that the content of tungsten was 0.5 mol% based on the total transition metals in the intermediate product.

As confirmed from the surface SEM image of FIG. 10, the positive electrode active material according to Comparative Example 6 included lithium transition metal oxides in both single particle and quasi-single particle forms. According to the ICP analysis result of the final product, the content of tungsten in the final product was found to be consistent with the designed composition.

Preparation Example 2. Manufacture of lithium secondary battery (half-cell)

A positive electrode slurry was prepared by dispersing 94 wt% of each positive electrode active material prepared according to Preparation Example 1, 3 wt% of carbon black, and 3 wt% of PVDF binder in 30 g of N-methyl-2-pyrrolidone (NMP). The positive electrode slurry was uniformly applied onto a 15 $\mu$m-thick aluminum thin film and vacuum dried at 135 °C to manufacture a positive electrode for a lithium secondary battery.

A half-cell was manufactured using a lithium foil as a counter electrode to the positive electrode, a porous polyethylene membrane (Celgard 2300, thickness: 25 $\mu$m) as a separator, and an electrolyte in which $LiPF_6$ was dissolved at a concentration of 1.15 M in a mixed solvent of ethylene carbonate and ethyl methyl carbonate at a volume ratio of 3:7.

Experimental Example 1. Analysis of Surface-Modified Positive Electrode Active Material

Referring to FIGS. 1 to 10, which show the surface SEM images of the positive electrode active materials (lithium transition metal oxides) according to the Examples and Comparative Examples prepared in Preparation Example 1, it can be confirmed that a coating layer formed in an island form was present on the surface of the surface-modified lithium transition metal oxides.

Meanwhile, referring to FIG. 6, it can be seen that the positive electrode active material according to Comparative Example 2 had a multi-particle form composed of more than 30 unit particles, unlike the other Examples and Comparative Examples.

The SEM/EDS analysis was performed as follows.

First, lithium transition metal oxides included in each of the positive electrode active materials prepared in Preparation Example 1 were selected, and each lithium transition metal oxide was cross-sectioned using a focused ion beam (FIB) with a Ga-ion source, followed by capturing cross-sectional FE-SEM images using a field emission scanning electron microscope. Subsequently, EDS mapping was carried out on the cross-sectional FE-SEM images to map tungsten (W), which was the target element, and the distribution of tungsten within the particles was analyzed.

Referring to FIGS. 11 and 12, which show the cross-sectional SEM/EDS images of the positive electrode active materials (lithium transition metal oxides in quasi-single particle form) according to Examples 2 and 3, it can be confirmed that a tungsten-containing coating layer was uniformly formed at the interfaces or gaps between unit particles.

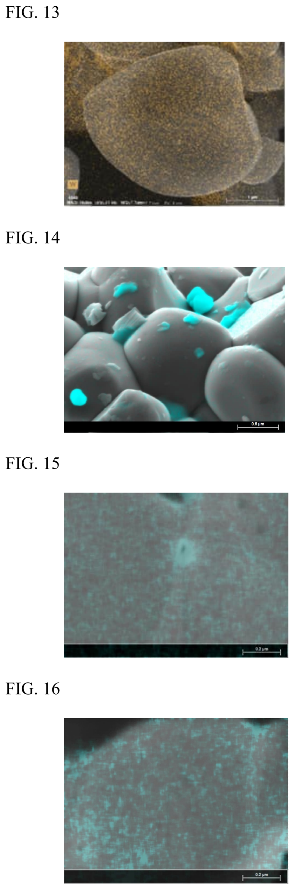

In addition, referring to FIG. 13, which shows the surface SEM/EDS image of the positive electrode active material (lithium transition metal oxide in quasi-single particle form) according to Example 2, it can be confirmed that tungsten was uniformly distributed on the surface of each unit particle, indicating that a uniform tungsten-containing coating layer was formed on the surface of the unit particles.

In contrast, referring to FIG. 14, which shows the surface SEM/EDS image of the positive electrode active material (lithium transition metal oxide in quasi-single particle form) according to Comparative Example 2, it can be observed that agglomeration of the coating material (tungsten) occurred on the surface of the unit particles. Further, referring to FIG. 15, which shows the cross-sectional SEM/EDS image of the positive electrode active material (lithium transition metal oxide in quasi-single particle form) according to Comparative Example 3, it can be observed that agglomeration of the coating material occurred at the interfaces or gaps between unit particles. This is presumed to be due to insufficient heat supply during the formation of the tungsten-containing coating layer on the surface of the lithium transition metal oxide, which resulted in insufficient diffusion of the coating material and its incomplete conversion into a coating layer.

Referring to FIG. 16, which shows the cross-sectional SEM/EDS image of the positive electrode active material (lithium transition metal oxide in quasi-single particle form) according to Comparative Example 4, it can be confirmed that no agglomeration of the coating material occurred at the interfaces or gaps between unit particles, but that most of the coating material had diffused into the unit particles.

As such, when tungsten introduced as the coating material diffuses into and is doped into the unit particles constituting the lithium transition metal oxide, the lattice strain of the lithium transition metal oxide may change.

Experimental Example 2. XRD analysis of positive electrode active material

X-ray diffraction (XRD) analysis was performed on each of the positive electrode active materials prepared according to Preparation Example 1 in order to analyze the crystallographic characteristics of the lithium transition metal oxide and the tungsten-containing coating layer included in the positive electrode active materials.

Specifically, the XRD analysis was carried out using a Bruker D8 Endeavor diffractometer with Cu-K$\alpha$ radiation ($\lambda$ = 1.540598 Å). From the diffraction spectra obtained by XRD analysis using Cu-K$\alpha$ radiation for the positive electrode active materials, the presence of a phase corresponding to lithium-tungsten oxide ($Li_2WO_4$) in the $2\theta$ range of 20.0° to 22.0° and a phase corresponding to tungsten oxide ($WO_3$) in the $2\theta$ range of 22.5° to 25.0° was confirmed.

The average crystallite size and the c-axis length were calculated from a straight line obtained by plotting $\theta$ (rad) of diffraction angles and $\beta$ (rad) of the full width at half maximum (FWHM) on a coordinate plane with $\sin\theta$ on the x-axis and $\beta\cos\theta$ on the y-axis, based on Rietveld refinement of the diffraction spectrum obtained from the XRD analysis of the positive electrode active material using Cu-K$\alpha$ radiation in the $2\theta$ range of 10° to 120°.

In addition, the lattice strain ($\varepsilon$) and the average crystallite size were calculated from the diffraction spectra obtained by X-ray diffraction (XRD) analysis using Cu-K$\alpha$ radiation for the positive electrode active materials.

The lattice strain and the average crystallite size were calculated by Rietveld Refinement of the diffraction spectra obtained by XRD analysis using Cu-K$\alpha$ radiation for the positive electrode active materials, by plotting the diffraction angle ($\theta$, rad) and the full width at half maximum ($\beta$, rad) within the $2\theta$ range of 10° to 120° on a coordinate plane where the horizontal axis represents $\sin\theta$ and the vertical axis represents $\beta\cos\theta$, and determining a straight line therefrom. The lattice strain ($\varepsilon$), expressed as $\Delta d/d$, was calculated as one-fourth of the slope of the straight line (or may be expressed as $\beta/4\tan\theta$).

Similarly, the average nickel (Ni) occupancy in the Li 3a site was calculated by Rietveld Refinement of the diffraction spectra obtained by X-ray diffraction (XRD) analysis using Cu-K$\alpha$ radiation for the positive electrode active materials.

The results of the XRD analysis are shown in Table 1 below.

[Table 1]

| Classification | Presence of $Li_2WO_4$ Peak | Presence of $WO_3$ Peak | Lattice Strain ($\varepsilon$) | Average Crystallite Size (nm) | Ni occupancy (%) |
|---|---|---|---|---|---|
| Example 1 | O | X | 0.00024 | 188.69 | 3.06 |
| Example 2 | O | X | 0.00024 | 194.22 | 2.99 |
| Example 3 | O | X | 0.00023 | 189.01 | 3.14 |
| Example 4 | O | X | 0.00024 | 192.08 | 3.10 |
| Comparative Example 1 | X | X | 0.00041 | 188.47 | 4.86 |
| Comparative Example 2 | O | X | 0.00035 | 147.51 | 4.75 |
| Comparative Example 3 | X | ○ | 0.00032 | 191.12 | 4.08 |
| Comparative Example 4 | X | X | 0.0004 | 203.65 | 4.04 |
| Comparative Example 5 | △ | ○ | 0.00029 | 201.42 | 3.30 |
| Comparative Example 6 | ○ | ○ | 0.00027 | 192.38 | 3.36 |

*"O" indicates that the corresponding diffraction peak was significantly detected; "△" indicates that the corresponding diffraction peak was weakly detected; and "X" indicates that no diffraction peak was detected.

Referring to Table 1, it can be confirmed that the positive electrode active materials according to Examples 1 to 4 included a phase corresponding to lithium-tungsten oxide ($Li_2WO_4$) but did not include a phase corresponding to tungsten oxide ($WO_3$). That is, it can be inferred that unreacted $WO_3$ was absent in the positive electrode active materials according to Examples 1 to 4, and that a $Li_2WO_4$-containing coating layer was formed on their surfaces.

The lattice strain ($\varepsilon$) values measured from the positive electrode active materials according to Examples 1 to 4 were 0.00025 or less, the average crystallite sizes were in the range of 160 to 200 nm, and the Ni occupancies were less than 3.5%.

In contrast, considering that the lattice strain ($\varepsilon$) measured from the positive electrode active material according to Comparative Example 1, which was not surface-modified, was 0.00041 or less, and the Ni occupancy was 4.86%, it can be confirmed that the surface modification described herein effectively relieved the lattice strain of the lithium transition metal oxide and also reduced the Ni occupancy.

Unlike the positive electrode active materials according to Examples 1 to 4, the positive electrode active material according to Comparative Example 2, which had a multi-particle form, exhibited a lattice strain ($\varepsilon$) of 0.00035, an average crystallite size of 147.51 nm, and an Ni occupancy of 4.75%.

The positive electrode active material according to Comparative Example 3 was confirmed to include a phase corresponding to tungsten oxide ($WO_3$) but not a phase corresponding to lithium-tungsten oxide ($Li_2WO_4$). This is presumed to be because the heat supplied during the formation of the tungsten-containing coating layer on the surface of the lithium transition metal oxide was insufficient, resulting in incomplete reaction between $WO_3$ and lithium. The positive electrode active material according to Comparative Example 3 exhibited a lattice strain ($\varepsilon$) of 0.00030 and an Ni occupancy of 3.67%.

The positive electrode active material according to Comparative Example 4, similar to that according to Comparative Example 1, did not include phases corresponding to $WO_3$ and $Li_2WO_4$. This is presumed to be because the tungsten introduced as the coating material diffused into and was doped into the unit particles constituting the lithium transition metal oxide, instead of forming a coating layer on the surface thereof. As predicted above, the lattice strain ($\varepsilon$) measured from the positive electrode active material according to Comparative Example 4 was 0.00040 due to the diffusion of tungsten into the unit particles, and the Ni occupancy was 4.04%.

Meanwhile, in the positive electrode active material according to Comparative Example 5, both the intensity of the peak corresponding to the $WO_3$ phase and the intensity of the peak corresponding to the $Li_2WO_4$ phase were found to be very weak. This is presumed to be because the amount of tungsten ($WO_3$) introduced as the coating material was excessively small, resulting in insufficient formation of a $Li_2WO_4$-containing coating layer. In the positive electrode active material according to Comparative Example 6, it was confirmed that unreacted $WO_3$ coexisted because the amount of tungsten ($WO_3$) introduced as the coating material was excessively large.

The lattice strain ($\varepsilon$) measured from the positive electrode active material according to Comparative Example 5 was 0.00029, and that measured from the positive electrode active material according to Comparative Example 6 was 0.00027, indicating that the amount of tungsten used for coating the surface of the lithium transition metal oxide can influence the lattice strain of the lithium transition metal oxide.

Experimental Example 3. Evaluation of electrochemical properties of lithium secondary battery (half-cell)

For the lithium secondary batterie (half-cell) manufactured in Preparation Example 2, charge/discharge experiments were conducted using an electrochemical analyzer (Toscat-3100 from TOYO SYSTEM CO., LTD.) at 25 °C, a voltage range of 3.0 V to 4.4 V, and a discharge rate of 0.1 C to 2.0 C to measure initial charging capacity, initial discharging capacity, initial efficiency, and 2.0C/0.1C rate capability (C-rate, discharge capacity ratio).

The measurement results are shown in Tables 2 and 3 below.

[Table 2]

| Classification | Charging Capacity (mAh/g) | Discharging Capacity (mAh/g) | Initial efficiency (%) | 2.0 C/0.1 C C-rate efficiency (%) |
|---|---|---|---|---|
| Example 1 | 216.2 | 192.4 | 89 | 84.8 |
| Example 2 | 217.2 | 193.2 | 88.9 | 85.0 |
| Example 3 | 217.2 | 191.4 | 88.6 | 84.7 |
| Example 4 | 216.4 | 192.4 | 88.1 | 84.5 |
| Comparative Example 1 | 214.7 | 185.8 | 86.6 | 81.3 |
| Comparative Example 2 | 215.7 | 190.8 | 88.4 | 82.2 |
| Comparative Example 3 | 212.5 | 187.0 | 88.0 | 82.8 |
| Comparative Example 4 | 218.1 | 186.3 | 85.4 | 82.5 |
| Comparative Example 5 | 217.3 | 188.3 | 86.7 | 82.7 |
| Comparative Example 6 | 214.4 | 189.9 | 88.6 | 83.0 |

Referring to the results shown in Table 2, it can be confirmed that the discharge capacity and rate capability of the lithium secondary batteries employing the positive electrode active materials according to Examples 1 to 4 were particularly improved. In addition, when compared with Comparative Example 2, which includes a multi-particle type lithium transition metal oxide, it can be seen that the capacity characteristics, initial efficiency, and rate capability of the lithium secondary batteries employing the positive electrode active materials according to Examples 1 to 4 were not deteriorated but rather improved.

Experimental Example 4. Analysis of Residual Lithium in the Positive Electrode Active Material

The content of residual lithium contained in each of the positive electrode active materials prepared according to Preparation Example 1 was quantitatively analyzed by a known method.

Specifically, 5 g of each positive electrode active material prepared according to Preparation Example 1 and 100 g of deionized water were placed in a 300 mL beaker, and the mixture was stirred at 300 rpm for 15 minutes using a magnetic bar. Thereafter, the suspension was filtered under reduced pressure using a vacuum flask, and 50 g of the filtrate was collected. The collected solution was placed in a titration vessel of an automatic titrator, and, with reference to the Wader Method, the contents of LiOH and $Li_2CO_3$ in the solution were measured by automatic titration with 0.1 N HCl.

The results of the residual lithium analysis are shown in Table 3 below.

[Table 3]

| Classification | LiOH (ppm) | $Li_2CO_3$ (ppm) | sum (ppm) |
|---|---|---|---|
| Example 1 | 597 | 419 | 1,016 |
| Example 2 | 401 | 632 | 1,033 |
| Example 3 | 440 | 677 | 1,117 |
| Example 4 | 473 | 698 | 1,171 |
| Comparative Example 1 | 837 | 2,751 | 3,588 |
| Comparative Example 2 | 770 | 1,427 | 2,197 |

(continued)

| Classification | LiOH (ppm) | $Li_2CO_3$ (ppm) | sum (ppm) |
|---|---|---|---|
| Comparative Example 3 | 545 | 1,214 | 1,759 |
| Comparative Example 4 | 460 | 743 | 1,203 |
| Comparative Example 5 | 500 | 963 | 1,463 |
| Comparative Example 6 | 611 | 798 | 1,409 |

When compared with the results of Comparative Example 1, which was not subjected to surface modification, it was confirmed that the positive electrode active materials according to Examples 1 to 4 exhibited a reduced content of residual lithium due to the surface modification.

In addition, the positive electrode active materials according to Examples 1 to 4, which include single-particle and quasi-single particle type lithium transition metal oxides, exhibited a further reduction in residual lithium content compared to Comparative Example 2, which includes a multi-particle type lithium transition metal oxide.

Accordingly, when the positive electrode active materials according to Examples 1 to 4 are used instead of the material of Comparative Example 2, it is expected that gas generation and swelling phenomena in lithium secondary batteries can be suppressed, thereby improving long-term cycle life characteristics.

According to the present invention, the lifetime characteristics and stability of a lithium secondary battery using the positive electrode active material defined herein can be improved by reducing the number of unit particles constituting a lithium transition metal oxide of a Mid-Ni type having a relatively low content of nickel (for example, about 70 mol% or less, or about 65 mol% or less).

According to the present invention, surface modification of a lithium transition metal oxide of a Mid-Ni type having a relatively low content of nickel (for example, about 70 mol% or less, or about 65 mol% or less) can reduce residual lithium on the surface and suppress surface side reactions between the lithium transition metal oxide and the electrolyte during charge and discharge, thereby suppressing and/or mitigating a swelling of the lithium secondary battery caused by gas generation.

In general, compared to a positive electrode active material including a High-Ni-type lithium transition metal oxide having a content of nickel exceeding 70 mol%, a positive electrode active material including a Mid-Ni-type lithium transition metal oxide having a relatively low content of nickel (for example, about 70 mol% or less, or about 65 mol% or less) may be less suitable for exhibiting appropriate driving characteristics under high-voltage operating conditions, because electrochemical properties related to the output of a lithium secondary battery, such as capacity characteristics and rate characteristics, tend to deteriorate.

In addition, as a content of manganese in the lithium transition metal oxide of a Mid-Ni type having a relatively low content of nickel becomes higher than a content of cobalt, kinetic properties such as lithium-ion conductivity tend to decrease, thereby deteriorating capacity and rate characteristics.

According to the present invention, by forming a tungsten-containing coating layer on the surface of the lithium transition metal oxide of a Mid-Ni type having a relatively low content of nickel (for example, about 70 mol% or less, or about 65 mol% or less) through low-temperature heat treatment, there can be provided a positive electrode active material exhibiting particularly improved discharge capacity and rate characteristics.

Although embodiments of the present invention have been described above, those skilled in the art can make various modifications and changes to the present invention by adding, changing, or deleting components without departing from the spirit of the present invention as set forth in the claims, which will be included within the scope of rights of the present invention.

**Claims**

1.  A positive electrode active material comprising:

    a lithium transition metal oxide having a crystal structure belonging to the R-3m space group and having a content of nickel in the range of 40 mol% or more and 70 mol% or less among transition metals; and
    a tungsten-containing coating layer located on the surface of the lithium transition metal oxide,
    wherein a lattice strain calculated through Rietveld Refinement of an X-ray diffraction (XRD) spectrum obtained using Cu-K$\alpha$ radiation is 0.00025 or less.

2.  The positive electrode active material according to Claim 1, wherein a content of cobalt among the transition metals is 10 mol% or less.

3. The positive electrode active material according to Claim 1 or Claim 2, wherein a content of manganese among the transition metals is 20 mol% or more and 50 mol% or less.

4. The positive electrode active material according to any one of Claims 1 to 3, wherein the lithium transition metal oxide further comprises cobalt and manganese, and a content of manganese among the transition metals is greater than a content of cobalt.

5. The positive electrode active material of any one of Claims 1 to 4, wherein the lithium transition metal oxide is represented by Chemical Formula 1 below,

[Chemical Formula 1]     $Li_aNi_{1-(b+c+d)}Co_bMn_cM1_dO_2$

wherein,

in the above Chemical Formula 1,
M1 is at least one selected from Na, K, Mg, Ca, Sr, Ba, Rb, B, Ce, Hf, Ta, Cr, F, Al, V, Ti, Fe, Zr, Zn, Si, Y, Nb, Ga, Sn, Mo, W, P, Ge, Nd, Gd, and Cu; and

$$0.95 \leq a \leq 1.15,\ 0 \leq b \leq 0.10,\ 0.20 \leq c \leq 0.50,\ 0 \leq d \leq 0.10,\ \text{and } 0.4 \leq 1-(b+c+d) \leq 0.7.$$

6. The positive electrode active material according to any one of Claims 1 to 5, wherein the lithium transition metal oxide has at least one form selected from a single particle form composed of one unit particle and a quasi-single particle form in which 30 or fewer unit particles are aggregated.

7. The positive electrode active material according to any one of Claims 1 to 6, wherein an average particle diameter $(D_{50})$ of the lithium transition metal oxide in the single particle form is in the range of 1.0 $\mu$m to 8.0 $\mu$m.

8. The positive electrode active material according to any one of Claims 1 to 7, wherein an average particle diameter $(D_{50})$ of the lithium transition metal oxide in the quasi-single particle form is in the range of 3.0 $\mu$m to 12.0 $\mu$m.

9. The positive electrode active material according to any one of Claims 1 to 8, wherein the coating layer comprises a lithium-tungsten oxide represented by Chemical Formula 2 below:

[Chemical Formula 2]     $Li_eW_fO_g$

wherein,
in the above Chemical Formula 2,

$$0 < e \leq 8,\ 0 < f \leq 15,\ \text{and } 0 < g \leq 20.$$

10. The positive electrode active material according to any one of Claims 1 to 9, wherein an average occupancy of nickel in a Li 3a site calculated through Rietveld Refinement of an X-ray diffraction (XRD) spectrum obtained using Cu-K$\alpha$ radiation is less than 3.5%.

11. The positive electrode active material according to any one of Claims 1 to 10, wherein an average crystallite size of the lithium transition metal oxide calculated through Rietveld Refinement of an X-ray diffraction (XRD) spectrum obtained using Cu-K$\alpha$ radiation is in the range of 160 nm to 200 nm.

12. The positive electrode active material according to any one of Claims 1 to 11, wherein the coating layer is formed in an island form discontinuously occupying the surface of the lithium transition metal oxide.

13. A positive electrode comprising the positive electrode active material of any one of Claims 1 to 12.

14. A lithium secondary battery comprising the positive electrode of claim 13.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

**EP 4 745 091 A1**

European Patent Office — Europäisches Patentamt — European Patent Office — Office européen des brevets

# EUROPEAN SEARCH REPORT

**Application Number**

EP 25 21 1640

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/129462 A1 (UMICORE NV [BE]) 23 June 2022 (2022-06-23) * page 3, line 9 - line 35 * * page 6, line 28 - page 7, line 7 * * page 11, line 36 - page 12, line 18; example 2; table 1 * ----- | 1-14 | INV. C01G53/504 H01M4/505 H01M4/525 H01M10/0525 |
| X | WO 2022/129473 A1 (UMICORE NV [BE]) 23 June 2022 (2022-06-23) * page 3, line 21 - page 4, line 9 * * page 7, line 1 - line 17 * * page 12, line 30 - page 13, line 14; example 2; table 2 * ----- | 1-14 | |
| A | CN 113 903 907 A (UNIV GUANGXI) 7 January 2022 (2022-01-07) * the whole document * ----- | 1-14 | |
| A | KR 2019 0078991 A (LG CHEMICAL LTD [KR]) 5 July 2019 (2019-07-05) * the whole document * ----- | 1-14 | TECHNICAL FIELDS SEARCHED (IPC) C01G H01M |

The present search report has been drawn up for all claims

| Place of search | Date of completion of the search | Examiner |
|---|---|---|
| Munich | 2 April 2026 | King, Ruth |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

26

## ANNEX TO THE EUROPEAN SEARCH REPORT
## ON EUROPEAN PATENT APPLICATION NO.

EP 25 21 1640

This annex lists the patent family members relating to the patent documents cited in the above-mentioned European search report.
The members are as contained in the European Patent Office EDP file on
The European Patent Office is in no way liable for these particulars which are merely given for the purpose of information.

02-04-2026

| Patent document cited in search report | | Publication date | Patent family member(s) | | Publication date |
|---|---|---|---|---|---|
| WO 2022129462 | A1 | 23-06-2022 | CA | 3202637 A1 | 23-06-2022 |
| | | | CN | 116635333 A | 22-08-2023 |
| | | | EP | 4264701 A1 | 25-10-2023 |
| | | | JP | 7641385 B2 | 06-03-2025 |
| | | | JP | 2023554106 A | 26-12-2023 |
| | | | KR | 20230121626 A | 18-08-2023 |
| | | | US | 2024030408 A1 | 25-01-2024 |
| | | | WO | 2022129462 A1 | 23-06-2022 |
| WO 2022129473 | A1 | 23-06-2022 | CA | 3202635 A1 | 23-06-2022 |
| | | | CN | 116601117 A | 15-08-2023 |
| | | | EP | 4264700 A1 | 25-10-2023 |
| | | | JP | 7727732 B2 | 21-08-2025 |
| | | | JP | 2023554416 A | 27-12-2023 |
| | | | KR | 20230121864 A | 21-08-2023 |
| | | | US | 2024030423 A1 | 25-01-2024 |
| | | | WO | 2022129473 A1 | 23-06-2022 |
| CN 113903907 | A | 07-01-2022 | NONE | | |
| KR 20190078991 | A | 05-07-2019 | NONE | | |

EPO FORM P0459

For more details about this annex : see Official Journal of the European Patent Office, No. 12/82